Europäisches Patentamt

European Patent Office

Office européen des brevets

(19)

(11) EP 0 949 688 A1

(12) EUROPÄISCHE PATENTANMELDUNG

(43) Veröffentlichungstag:
13.10.1999 Patentblatt 1999/41

(51) Int. Cl.⁶: H01L 31/075, H01L 31/0376,
H01L 31/20

(21) Anmeldenummer: 98105897.7

(22) Anmeldetag: 31.03.1998

(84) Benannte Vertragsstaaten:
AT BE CH DE DK ES FI FR GB GR IE IT LI LU MC
NL PT SE
Benannte Erstreckungsstaaten:
AL LT LV MK RO SI

(71) Anmelder:
Phototronics Solartechnik GmbH
85640 Putzbrunn (DE)

(72) Erfinder:
• Bauer, Stefan
66871 Pfefelbach (DE)

• Herbst, Wolfgang, Dr.
78464 Konstanz-Egg (DE)
• Schroeder, Bernd, Dr.
67663 Kaiserslautern (DE)

(74) Vertreter:
Haft, von Puttkamer, Berngruber, Czybulka
Patentanwälte
Franziskanerstrasse 38
81669 München (DE)

(54) **Dünnschichtsolarzelle, Verfahren zu deren Herstellung sowie Vorrichtung zur Durchführung des Verfahrens**

(57) Bei einer Dünnschichtsolarzelle mit wenigstens einer p-leitenden Schicht, einer intrinsischen Schicht aus amorphem Silizium und einer n-leitenden Schicht (p-i-n-Struktur) weist die intrinsische Schicht an der Grenzfläche zur p-leitenden Schicht eine intrinsische Grenzschicht auf, die einen geringeren Wasserstoffgehalt und eine größere Dichte als die restliche intrinsische Schicht besitzt. Die intrinsische Schicht wird auf der p-leitenden Schicht nach dem "Hot-Wire"-Verfahren thermokatalytisch abgeschieden, wobei die Temperatur des Filaments zur Steuerung der Schichteigenschaften eingestellt wird, und die Temperatur des Substrats weniger als 300° C beträgt. Das "Hot-Wire"-Verfahren kann mit einer evakuierbaren Kammer durchgeführt werden, in der in einem Abstand vom Substrathalter ein Tantaldraht, an dem wenigstens ein Gewicht angreift, mäanderförmig aufgespannt ist.

FIG. 1

EP 0 949 688 A1

## Beschreibung

Die Erfindung bezieht sich auf eine Dünnschichtsolarzelle mit wenigstens einer p-leitenden Schicht, einer darauf abgeschiedenen intrinsischen Schicht aus wasserstoffhaltigem amorphem Silizium (kurz: a-Si:H) und einer n-leitenden Schicht (p-i-n Struktur) sowie auf ein Verfahren zur Herstellung einer solchen Solarzelle, bei dem zur Abscheidung der intrinsischen Schicht ein erhitzter Draht verwendet wird, dem ein Siliziumwasserstoffgas, vorzugsweise Silan, zugeführt wird (Thermokatalyse). Diese Erfindung hat auch eine Vorrichtung zur Durchführung dieses Verfahrens zum Gegenstand.

Für die Herstellung von photovoltaischen Solarzellen stellt a-Si:H aus wirtschaftlichen Gründen und wegen der hohen Flexibilität bei der Herstellung eine sinnvolle Alternative zu kristallinem Silizium dar. Für die Abscheidung des a-Si:H wird im industriellen Maßstab vor allem die plasmaunterstützte chemische Gasphasenabscheidung („Plasma Enhanced Chemical Vapour Deposition" oder kurz PECVD) von siliziumhaltigen Gasen oder Gasgemischen angewendet. Dabei werden auf einem transparenten Substrat, auf dem eine transparente leitfähige Elektrode aufgebracht ist, p-leitende, intrinsische, also undotierte, und n-leitende Schichten aus amorphem Silizium oder amorphen Siliziummischhalbleitern in dieser Reihenfolge aufeinander abgeschieden (p-i-n-Zelle). Zur Abscheidung von bauelementtauglichem (sog. „device grade") a-Si:H muss die Abscheiderate beim PECVD-Verfahren im großflächigen industriellen Prozess jedoch auf Werte um 1 Å/s begrenzt werden. Zwar kann man prinzipiell durch hohe Plasmaanregungsfrequenzen, hohe Plasmaleistungen oder hohe Silanpartialdrücke, insbesondere auf kleinen Flächen, höhere Raten erreichen; jedoch sinkt die erreichbare Abscheiderate für gleichförmig homogene Schichten mit zunehmender Substratfläche. Zusätzlich geht mit der Erhöhung der Abscheiderate bei großflächiger Abscheidung eine Plasmapolymerisation in der Gasphase einher, die zu unerwünschter, wirkungsgradreduzierender Pulverbildung führt.

Eine deutliche Erhöhung der Abscheiderate wurde nach dem aus der Literatur bekannten sog. „Hot-Wire" (HW)-Verfahren erzielt, bei dem zur Abscheidung der intrinsischen Schicht aus a-Si:H ein erhitzter Draht verwendet wird, dem Silan zur thermischen Zersetzung zugeführt wird (US-Patent 5,397,737; J. Appl. Phys. 82(4)(1997)1909). Dabei wird eine Abscheiderate von 5-10 Å/s erreicht.

Es wird ein Wolframdraht verwendet, der während der Abscheidung der a-Si:H-Schicht auf eine hohe Temperatur von ungefähr 2000°C erwärmt wird, während das Substrat, auf dem das a-Si:H abgeschieden wird, auf eine Temperatur von wenigstens 330°C und höchstens 630°C erwärmt wird. Die hohe Temperatur des Substrats von mindestens 330°C oder höher stellt aber einen wesentlichen Nachteil des bekannten Verfahrens dar. Denn dadurch wird der Energieverbrauch spürbar erhöht.

Des weiteren werden Solarmodule mit p-i-n-Schichtfolge auf einem Glas/TCO-Substrat bereits industriell hergestellt (sog. Superstrat-Technologie). Wenn das amorphe Silizium auf dem Glas/TCO-Substrat bei einer Substrattemperatur von mehr als 250°C, insbesondere mehr als 300°C abgeschieden wird, ist jedoch ein deutlicher Abfall der Leistungsabgabe der Solarzelle festzustellen. Dies dürfte auf eine Zerstörung der p-Schicht durch Diffusion der Metallatome aus der TCO-Schicht zurückzuführen sein.

Eine Aufgabe der Erfindung ist es, ein HW-Verfahren bereitzustellen, mit dem eine Dünnschichtsolarzelle aus amorphem Silizium mit einer erhöhten Abscheiderate der a-Si:H-Schicht bei niedrigerer Temperatur, im Vergleich zum oben erwähnten, bekannten HW-Verfahren, mit einem hohen Wirkungsgrad und minimaler Wirkungsgraddegradation hergestellt werden kann.

Durch die Erfindung wird eine Dünnschichtsolarzelle mit wenigstens einer p-leitenden Schicht, einer intrinsischen Schicht aus amorphem Silizium und einer n-leitenden Schicht (p-i-n-Struktur) bereitgestellt, bei der die intrinsische Schicht an der Grenzfläche zur p-leitenden Schicht eine intrinsische Grenzschicht aufweist, die einen geringeren Wasserstoffgehalt und eine höhere Dichte als die restliche intrinsische Schicht besitzt.

Nach dem erfindungsgemäßen Verfahren erfolgt die Abscheidung der intrinsischen Silizium-Schicht nach dem "Hot Wire"-Verfahren bei weniger als 300°C, insbesondere bei weniger als 250°C und bevorzugt bei lediglich 200°C oder weniger. Das erfindungsgemäße Verfahren hat damit den erheblichen Vorteil, dass es direkt in der bereits ausgereiften Superstrat-Technologie eingesetzt werden kann.

Die Erfindung erstreckt sich nicht nur auf das Material a-Si:H, sondern kann im Prinzip auf alle nichtkristalline Halbleiter auf Si-Basis angewendet werden, insbesondere auf Si-basierende Mischhalbleiter mit weiteren Elementen, z.B. Germanium oder Kohlenstoff, als auch auf mikrokristalline ($\mu$c), nanokristalline (nc) und feinkristalline Halbleiter.

Durch die Erfindung kann zusätzlich eine höhere Abscheiderate als beim PECVD-Verfahren erreicht werden.

Ein wesentlicher Aspekt der Erfindung ist, dass die Steuerung der Depositionsrate über die Drahttemperatur erfolgt, d.h.: Je heißer der Draht, desto höher die Depositionsrate. Mit der Drahttemperatur ändert sich jedoch nicht nur die Rate, sondern es ändern sich auch die Prozeßgaszersetzung und somit der Aufwachsprozeß der Schicht. Dies hat erheblichen Einfluß auf die Schichteigenschaften und muss bei der Herstellung der a-Si:H-Solarzelle berücksichtigt werden. Erfindungsgemäß wird zunächst bei niedriger Drahttemperatur, d.h. einer langsameren Rate eine erste intrinsische Schicht auf eine p-dotierte Schicht abgeschieden (p/i-Zwischen- oder Grenzschicht). Danach wird die Drahttemperatur erhöht und eine zweite intrinsische Schicht (Hauptschicht) bei deutlich erhöhter Rate auf die erste intrinsische Schicht abgeschieden.

Die Temperatur des Drahtes beträgt in der Anfangsphase zur Abscheidung der intrinsischen Grenzschicht auf der p-leitenden Schicht vorzugsweise höchstens 1600°C, insbesondere weniger als 1500°C, während sie nach der Anfangsphase auf mehr als 1500°C, insbesondere 1600°C oder mehr erhöht wird. Als besonders geeignet hat sich für das erfindungsgemäße Verfahren ein Tantal-Draht erwiesen. Wolframdrähte dagegen werden wegen der starken Silizidbildung bei diesen relativ niedrigen Drahttemperaturen bereits nach kurzer Betriebsdauer unbrauchbar.

Die Abscheiderate in der Anfangsphase zur Ausbildung der intrinsischen Grenzschicht beträgt weniger als 2,5 Å/s, vorzugsweise weniger als 2 Å/s, insbesondere ca.1 Å/s oder noch weniger. Nach der Bildung der intrinsischen Grenzschicht kann die Abscheiderate auf ungefähr das Doppelte, z.B. auf 2, 4 oder 5 Å/s und mehr erhöht werden.

Anzumerken ist, dass die Rate auch durch andere Prozeßparameter (siehe weiter unten) gesteuert werden kann.

Ein weiterer Aspekt der Erfindung ist, dass durch das anfängliche langsame Aufwachsen an der p-leitenden/intrinsischen Grenzfläche, dem p/i-Übergang, eine Grenzschicht aus besonders dichtem, wasserstoffarmem intrinsischen amorphen Silizium gebildet wird. Diese sehr gute anfängliche Schichtqualität hat einerseits eine positive Auswirkung auf den Solarzellenwirkungsgrad, und sie fördert andererseits ein günstiges Schichtwachstum bei der weiteren Abscheidung der Solarzelle, auch wenn anschließend die Abscheiderate zur Bildung der intrinsischen (Haupt-) Schicht erhöht wird.

Die in der Anfangsphase der Abscheidung am p/i-Übergang gebildete erste intrinsische Grenzschicht sollte eine Schichtdicke von mindestens 5 nm besitzen, vorzugsweise mehr als 10 nm und insbesondere etwa 20 nm. Eine wesentlich dickere erste Schicht führt zu einer Herabsetzung der mittleren Abscheiderate der Gesamt-i-Schicht, ohne die Qualität der Solarzelle wesentlich zu verbessern. Das heißt, die Dicke der intrinsischen Grenzschicht sollte maximal 20%, vorzugsweise maximal 10%, insbesondere ca. 5% der Gesamtdicke der intrinsischen Schicht betragen.

Die intrinsische Grenzschicht weist einen Wasserstoffgehalt von weniger als 15 at.%, vorzugsweise weniger als 10 at.%, insbesondere weniger als 5 at.% auf.

Der Partialdruck des benutzten Siliziumwasserstoffgases, bevorzugt des Silans, während der Abscheidung der intrinsischen amorphen Siliziumschicht beträgt vorzugsweise weniger als 20 mTorr, insbesondere weniger als 10 mTorr. Der Abstand des erhitzten Drahtes von dem Substrat kann zwischen 2 und 8 cm, insbesondere etwa 5 cm betragen.

Das erfindungsgemäße Verfahren kann insbesondere zur Herstellung von amorphen Siliziumdünnschichtsolarzellen verwendet werden, die die Schichtfolge p-leitend, intrinsisch (i) und n-leitend (d.h. p-i-n) aufweisen. Neben p-i-n-Einfachzellen können mit dem erfindungsgemäßen Verfahren auch Tandem- oder Stapelzellen, die die doppelte Schichtenfolge p-i-n/p-i-n besitzen, oder auch Tripelzellen (dreifache Schichtenfolge p-i-n/p-i-n/p-i-n) realisiert werden. Auch die umgekehrten Schichtfolgen (inverse(n) Struktur(en)) n-i-p, n-i-p/n-i-p bzw. n-i-p/n-i-p/n-i-p sind möglich.

Die Dotierung der p- bzw. n-leitenden Schicht erfolgt im allgemeinen durch Einbau von z.B. Bor- oder Phosporatomen während der Gasphasenabscheidung durch Beimischung von Dotiergasen zum Prozeßgas. Das heißt, zu dem Silan werden beispielsweise die Dotiergase Diboran ($B_2H_6$) bzw. Trimethylbor ($B(CH_3)_3$) für die p-typ-Dotierung oder Phosphin ($PH_3$) für die n-typ Dotierung zugemischt.

Die Herstellung der p- und n-Schicht kann nach einem beliebigen Verfahren erfolgen, beispielsweise durch PECVD, durch Sputtern oder mit der „Hot-Wire"-Methode.

Zwar ist es möglich, die p-i-n-Schichtfolge diskontinuierlich aufzubringen, also beispielsweise nach Abscheidung der p-leitenden Schicht auf dem Substrat dieses aus dem Abscheidereaktor herauszunehmen und in einen „Hot-Wire"-Reaktor zu geben; vorzugsweise wird die Abscheidung sämtlicher Schichten jedoch hintereinander im gleichen Reaktor kontinuierlich, zumindest ohne Brechen des Vakuums durchgeführt, d.h. die Solarzelle wird dem Reaktor erst nach vollständig abgeschiedener Schichtfolge entnommen. Dabei kann der Reaktor auch ein Mehrkammerreaktor sein, wobei die Schichten der verschiedenen Leitungstypen jeweils in einer Kammer abgeschieden werden.

Als Substrat wird für die Solarzelle insbesondere Glas verwendet, das mit einer transparenten Kontaktschicht aus einem elektrisch leitendem Metalloxid (Transparent Conductive Oxide: TCO), beispielsweise aus Zink- oder Zinnoxid versehen ist, auf der die Schichtfolge p-i-n einfach oder mehrfach abgeschieden wird.

Die nachstehende Darstellung von durchgeführten Experimenten dient der weiteren Erläuterung der Erfindung.

## Einfluß der Filamenttemperatur

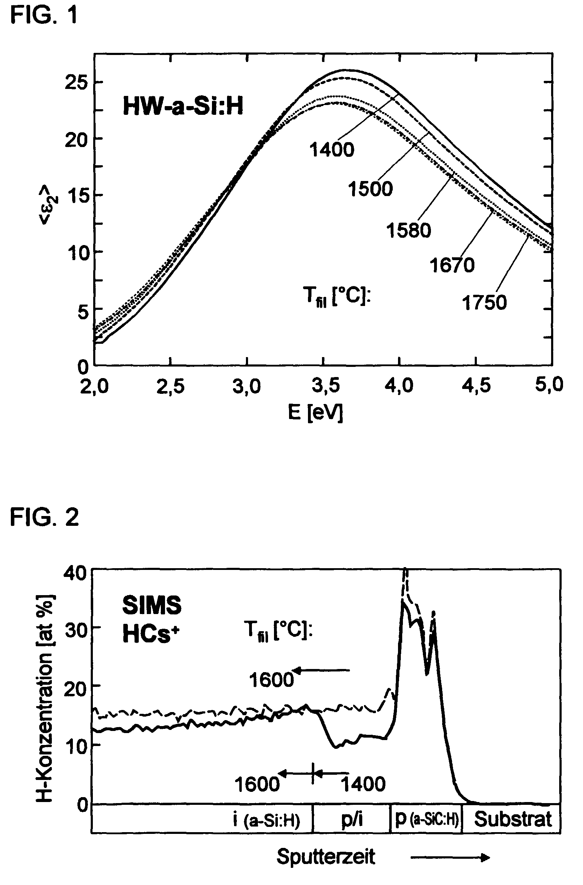

Im folgenden werden die Ergebnisse einer Untersuchung (Versuchsreihe 1) von Schichteigenschaften von HW-i-Materialien gezeigt, die Aufschluß über die Abhängigkeit dieser Schichteigenschaften von der Filamenttemperatur $T_{fil}$ geben sollen. Für die Untersuchung wurde $T_{fil}$ systematisch variiert. Unter sonst gleichen Abscheidebedingungen wurden die i-Schichten bei $T_{fil}$ =1400°C, 1500°C, 1580°C, 1670°C und 1750°C auf c-Si-Substrate abgeschieden. Hierzu zeigt Figur 1 in situ bestimmte spektroskopische Ellipsometriedaten, speziell den Imaginärteil der dielektrischen

Funktion $\langle \varepsilon_2 \rangle$ in Abhängigkeit von der eingestrahlten Photonenenergie E für verschiedene $T_{fil}$. Die Messungen wurden durchgeführt in Anlehnung an R.W. Collins in „Amorphous Silicon and Related Materials" (ed.: H. Fritzsche), World Scientific (Singapore 1988), p. 1003-1044. In einer ersten Näherung kann der maximale Wert von $\langle \varepsilon_2 \rangle$ mit der Dichte der Schicht korreliert werden. Jede Abweichung des $\varepsilon_2 = f(E)$-Maximums zu niedrigeren Energien als 3.6 eV indiziert eine Erhöhung der Oberflächenrauhigkeit. Wie Fig. 1 zeigt, weisen die Schichten, die mit hoher $T_{fil}$ abgeschieden wurden, eine Mikrostruktur mit geringer Dichte und hoher Oberflächenrauhigkeit auf. Die mit niedriger $T_{fil}$ abgeschiedenen Schichten hingegen sind sehr kompakt (hohe Dichte) und besitzen eine relativ glatte Oberfläche. Zusätzlich durchgeführte Untersuchungen zeigen eine Korrelation der Schichtdichte zur elektronischen Qualität des Materials. Ein Kriterium für die Tauglichkeit eines Materials für den Einsatz in Halbleiterbauelementen, insbesondere Solarzellen, ist die durch die ambipolare Diffusionslänge $L_{amb}$ charakterisierte Beweglichkeit der Minoritätsladungsträger. Unsere Messungen ergaben für die Schichten mit $T_{fil} = 1750°C$ einen Wert von lediglich $L_{amb} = 90nm$, bei $T_{fil} = 1500°C$ hingegen einen Wert $L_{amb} > 200nm$. Wird nun ein HW-a-Si:H-Material dieser günstigen Mikrostruktur und ausgezeichneten elektronischen Qualität als Zwischen- oder Grenzschicht zwischen p- und i-Schicht eingesetzt, wird die Grenzflächendefektdichte am p/i-Übergang wesentlich und entscheidend reduziert. Die strukturellen und elektronischen Eigenschaften der auf dieser Grenzflächenschicht abgeschiedenen Haupt-i-Schicht sind ebenfalls besser, scheinen aber weniger kritisch.

Aus verschiedenen Untersuchungen an a-Si:H-Schichten und a-Si:H-Schichtsystemen ist bekannt, dass der Wasserstoffeinbau und insbesondere der Wasserstoffgehalt für ihre Dichte und auch ihre elektronischen Eigenschaften von entscheidender Bedeutung ist. Daher wurden H-Konzentrationstiefenprofile für verschiedene HW-a-Si:H-Schichtsequenzen bestimmt (Versuchsreihe 2). Dazu wurde zuerst auf ein c-Si Substrat, auf das eine p-a-SiC:H-Schicht aufgebracht war, eine HW-a-Si:H Schicht abgeschieden. Die Temperatur des Tantaldrahtes $T_{fil}$ betrug während des gesamten Abscheidevorgangs 1600°C. Das Experiment wurde wiederholt, mit dem Unterschied, dass zu Beginn der Abscheidung $T_{fil}$ zunächst 1400°C betrug und erst nach der Abscheidung dieser intrinsischen Grenzschicht auf 1600°C erhöht wurde. Die beschriebenen Schichtstrukturen wurden mittels Sekundärionen-Massenspektrometrie (SIMS) untersucht.

Dabei wurde die MCs$^+$-Technik angewendet (J. Vac.Sci.Technol. A12(1994)452), bei der die zu untersuchende Probe mit Cäsium (Cs)-Ionen der Energie 5,5 keV beschossen wird, wobei „M" für das zu analysierende Ion, hier also für das Wasserstoffion (H) steht.

In Figur 2 sind die H-Konzentrationsprofile für die zwei zu vergleichenden Schichtstrukturen dargestellt, wobei auf der Abszisse die Sputterzeit für die Materialabtragung, d.h. eine zur Schichtdicke proportionale Größe, aufgetragen ist. Dabei weist die Schichtstruktur des bei konstanter $T_{fil}$ abgeschiedenen Schichtstruktur über die gesamte i-Schicht hinweg einen konstanten H-Gehalt von ca. 15 at.% (gestrichelte Linie in Fig. 2) auf. Demgegenüber zeigt die Vergleichsstruktur zunächst für die p/i-Grenzschicht ($T_{fil} = 1400°C$) eine H-Konzentration von ca. 10 at.%, die auf 15-16 at.% ansteigt ($T_{fil} = 1600°C$) und dann leicht abnimmt (durchgezogenen Linie in Fig. 2).

Aus den geschilderten Ergebnissen der SIMS-Tiefenprofil-Analyse (Bestimmung der H-Konzentration) ist eine deutliche Modifizierung der p/i-Grenzschicht bei Variation der Filamenttemperatur zu erkennen (Der hohe H-Gehalt der p-Schicht (> 30 at.%) ist für p-a-SiC:H-Material üblich). Die Abnahme der H-Konzentration an der p/i-Grenzfläche bei erniedrigter $T_{fil}$ bedeutet - analog den Ergebnissen der Ellipsometrie-Versuchsreihe -, dass eine besonders kompakte (dichte) a-Si-Schicht aufwächst. Diese hohe Materialdichte an der Grenzfläche führt zu einem Netzwerk mit einer geringen Anzahl von Grenzflächendefekten. Dadurch werden die Rekombinationsverluste der Ladungsträger an dieser Grenzfläche deutlich vermindert.

**HW-a-Si:H-Solarzellen**

Die Präparation der HW-a-Si:H-Solarzellen erfolgte auf folgende Art und Weise:

Auf die TCO-Schicht auf einem Glassubstrat wurde mittels einer PECVD-Anlage eine p-leitende amorphe Siliziumkohlenstoffschicht (a-SiC:H) mit einer Schichtdicke von etwa 9 nm aufgetragen. Zur Bildung der ca. 500 nm dicken i-Schicht wurde das mit der p-Schicht versehene Glas/TCO-Substrat in einen UHV-Abscheidereaktor gegeben, der mit einem heizbaren Draht versehen ist. Als heizbarer Draht wurde ein W-förmiges Tantal-Filament mit einem Drahtdurchmesser von 0,5 mm verwendet. Der Abstand des Substrates von dem Draht betrug 5 cm.

Der Reaktor wurde evakuiert, die Temperatur des Substrats ($T_s$) auf ca. 200°C eingestellt . Der Gasfluß des Silans betrug 20 sccm.

Das intrinsische amorphe Silizium wurde auf einer Fläche von 5 cm x 5 cm auf der p-Schicht abgeschieden.

Nach Bildung der intrinsischen Schicht wurde die „Hot-Wire"-Abscheidung unterbrochen und das Glas/TCO-Substrat mit der p- und der i-Schicht nach dem Abkühlen in eine Sputter-Kammer gegeben, in der auf die i-Schicht eine 25 nm dicke n-leitende amorphe Siliziumschicht gesputtert wurde. Auf die n-Schicht wurde als Rückkontakt ein Aluminiumfilm aufgedampft.

Die unten stehende Tabelle 1 zeigt einige Beispiele von a-Si:H-Solarzellen, deren i-Schicht mit dem erfindungsgemäßen HW-Verfahren hergestellt wurden. Bei der Herstellung dieser Solarzellenserie wurde der Parameter Drahttemperatur (Filamenttemperatur $T_{fil}$) des Tantaldrahtes variiert, sowohl während der Abscheidung der p/i-Grenzschicht als auch der i-Hauptschicht (Versuchsreihe 3). Ebenfalls einen erheblichen Einfluß auf die Solarzelleneigenschaften hat der Parameter Prozeßgasdruck (hier nicht gezeigt). Das Qualitätsmerkmal der Zellen ist der nach der Abscheidung gemessenen Wirkungsgrad $\eta_o$.

Tabelle 1

| Versuchsreihe 3 | $T_{fil}$ [°C] p/i- Grenzschicht | $T_{fil}$ [°C] i- Schicht | $\eta_o$ [%] |
|---|---|---|---|
| 1 | 1650 | 1650 | 2.4 |
| 2 | 1450 | 1620 | 8.4 |
| 3 | 1450 | 1500 | 9.7 |

Die Versuchsreihe 3 (Beispiele 1-3) zeigt deutlich, dass durch die Erniedrigung von $T_{fil}$ während der Abscheidung der p/i-Grenzschicht eine deutliche Erhöhung des Wirkungsgrades erreicht wird. Das heißt: Es ist notwendig, für die Abscheidung von hochwertigen HW-a-Si:H-Solarzellen die Rate, zumindest zu Beginn der Abscheidung, deutlich abzusenken.

Wie schon erwähnt, ist eine Abscheidemethode für a-Si:H-Solarzellen aber nur dann für Anwender interessant, wenn ein Durchsatz bei der Herstellung erreicht wird, der eine wirtschaftliche Herstellung aussichtsreich erscheinen läßt. Dazu muß die Abscheiderate für die Gesamtschichtdicke der i-Schicht erhöht werden, ohne dass hiermit Qualitätseinbußen für die Solarzelle verbunden sind. Eine Steigerung der Abscheiderate kann erreicht werden entweder durch die Erhöhung der Filamenttemperatur oder die Erhöhung des Silanpartialdrucks. Auch die gleichzeitige Variation beider Parameter ist möglich. Es wurde daher eine weitere Versuchsreihe durchgeführt. Dabei wurde die Rate für die p/i-Grenzschicht konstant auf ungefähr 1 Å/s eingestellt. Die Rate für die i-Hauptschicht wurde variiert (erhöht).Die Ergebnisse dieser Versuchsreihe 4 in Tabelle 2 (Beispiele 4 bis 7) belegen, dass man die Rate bei der Abscheidung der i-Hauptschicht und damit die mittlere Rate bei der Abscheidung der Gesamt-i-Schicht deutlich erhöhen kann, ohne dass eine starke Reduzierung des Wirkungsgrades hingenommen werden muß.

Tabelle 2

| Versuchsreihe 4 | Rate (i-Hauptschicht) [Å/s] | mittlere Rate (Gesamt-i- Schicht) [Å/s] | $\eta_0$ [%] |
|---|---|---|---|
| 4 | 2 | 1,6 | 9,9[1] |
| 5 | 2,8 | 2,1 | 9,7[1] |
| 6 | 4,0 | 2,4 | 9,2[2] |
| 7 | 8,5 | 4,2 | 8,5[2] |

[1] mit Antireflexbeschichtung hergestellt
[2] ohne Antireflexbeschichtung hergestellt. Antireflexschicht wurde jedoch bei der Bestimmung von $\eta_0$ für Vergleichbarkeit mit Beispielen 4 und 5 berücksichtigt.

Es ist wahrscheinlich, dass durch eine Optimierung der Abscheideparameter mittlere Raten von 5 Å/s für hochwertige HW-a-Si:H-Solarzellen der beschriebenen erfindungsgemäßen Ausführung erreicht werden können.

**Betrachtungen zur Stabilität**

Ein Problem der a-Si:H-PV-Technologie ist die Verschlechterung der Schichteigenschaften durch die Entstehung von metastabilen Defekten bei Lichteinfall und die damit einhergehende Zelldegradation (Staebler-Wronski-Effekt). Da die Defekterzeugung durch den Lichteinfall selbstlimitierend ist, kann man den Degradationsvorgang als Stabilisierung beschreiben.

Die Bestrebungen, a-Si:H-Material mit höherer Stabilität (geringerer Anfälligkeit gegen Lichtalterung) zu gewinnen, führte zu den schon eingeführten Arbeiten (US-Patent 5.397.737; J. Appl. Phys. 82(4)(1997)1909) über HW-a-Si:H-Material. Darin wurde gezeigt, dass die bei hohen Substrattemperaturen ($T_s$ = 330°C bis 630°C) hergestellten a-Si Schichten einen H-Gehalt von ≈1-2 at.% aufweisen und deutlich stabiler gegenüber Lichteinstrahlung als herkömmliche, mit dem PECVD-Verfahren hergestellte Schichten sind. Da die Abscheidetemperatur bei dem PECVD-Prozeß üblicherweise 200 - 300°C beträgt, enthalten so präparierte a-Si:H-Schichten ≈12-15 at.% Wasserstoff.

Es sind Modifizierungen des PECVD-Prozesses für a-Si:H-Solarzellen bekannt - Abscheidung bei einer tieferen Temperatur in Kombination mit einer hohen H-Verdünnung des Silans bei der Deposition der i-Schicht -, die zu einem verbesserten Stabilisierungsverhalten führen (Proc. 23$^{rd}$ IEEE PVSC, Louisville, Ky (1993), S. 790). Im Gegensatz dazu hat ein Zusatz von Wasserstoff zum Silan für die bisher bekannten HW-Schichten keine Verbesserungen erbracht (s. erwähnte Literaturstelle aus J. Appl. Phys. 82(4)).

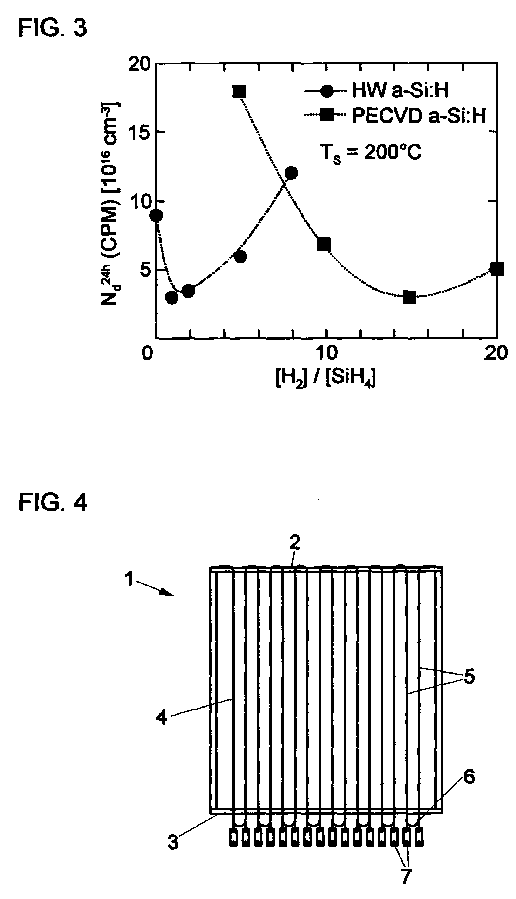

In einer vergleichenden Untersuchung an HW- und PECVD-a-Si-Schichten (Versuchsreihe 5) wurde der Einfluß der H-Verdünnung auf die elektronischen Eigenschaften getestet. Die Substrattemperatur ist für alle Proben $T_s$ = 200°C. $T_{fil}$ für die HW-Proben beträgt 1500°C. In Figur 3 ist die nach 24 Stunden Blitzlampenalterung mittels CPM (Constant Photocurrent Method) ermittelte Defektdichte in Abhängigkeit vom H-Verdünnungsverhältnis $[H_2]:[SiH_4]$ aufgetragen. Die PECVD-Schichten zeigen ein ausgeprägtes Minimum bei einem Verdünnungsverhältnis von etwa 15:1. Für die Präparation mit dem Hot-Wire-Prozeß ergibt sich dagegen eine maximale Schichtstabilität bei einer wesentlich geringeren Verdünnung von etwa 1:1. Dies zeigt, dass mit den verschiedenen Verfahren Schichten abgeschieden werden, die unterschiedliche Mikrostrukturen aufweisen, und als Konsequenz daraus resultieren die beobachteten unterschiedlichen Eigenschaften und Verhalten.

Erfindungsgemäß wird also das Silan vorzugsweise mit Wasserstoff verdünnt, und zwar in einem Volumenverhältnis von vorzugsweise 1:0,2 bis 1:5, insbesondere 1:0,5 bis 1:2.

## Großflächige Abscheidung

Während in den vorstehenden Experimenten die a-Si:H-Abscheidungen im Labormaßstab stattfanden, ist es für die praktische Anwendung notwendig, die Technologie auf größere Flächen im m$^2$-Bereich aufzuskalieren.

Dies kann in einem großflächig ausgelegten Abscheidereaktor realisiert werden, in dessen evakuierbarer Kammer planparallel zum Substrathalter ein Gitter angeordnet ist, das aus einem Rahmen aus vorzugsweise keramischem Material besteht, an dem ein Tantal-Draht mäanderförmig aufgespannt ist.

In Fig. 4 ist eine spezielle Ausführungsform eines solchen Gitters dargestellt.

Das Gitter weist einen rechteckigen Rahmen 1 aus einem hitzebeständigen keramischen Material (Marcor ®) auf. Über die einander gegenüberliegenden Längsseiten 2, 3 des Rahmens ist ein Tantal-Draht 4 mäanderförmig gespannt, so dass sich parallele, im gleichen Abstand voneinander angeordnete Drahtabschnitte 5 ergeben, die durch um die Längsstäbe 2, 3 verlaufende Abschnitte 6 miteinander verbunden sind.

An den Verbindungsabschnitten 6 des Tantal-Drahtes 4 hängen jeweils Gewichte 7, wodurch der Draht 4 ständig optimal gespannt wird, so dass sich eine thermische Ausdehnung nicht negativ auf die Filamentgeometrie und damit auf die Abscheidehomogenität auswirken kann. Dies ist wichtig, da man dadurch eine besser reproduzierbare Drahtgeometrie erhält, die nicht von der thermischen Vorgeschichte des Drahtes 4 abhängt.

Anders als beim PECVD-Abscheideverfahren gibt es bei der HW-Abscheidemethode keine Probleme, die hohen Depositionsraten der Laborfläche großflächig umzusetzen und zu erhalten bzw. zu erhöhen.

## Patentansprüche

1. Dünnschichtsolarzelle mit wenigstens einer p-leitenden Schicht, einer intrinsischen Schicht aus amorphem Silizium und einer n-leitenden Schicht (p-i-n-Struktur), dadurch gekennzeichnet, dass die intrinsische Schicht an der Grenzfläche zur p-leitenden Schicht eine intrinsische Grenzschicht aufweist, die einen geringeren Wasserstoffgehalt und eine größere Dichte als die restliche intrinsische Schicht besitzt.

2. Dünnschichtsolarzelle nach Anspruch 1, dadurch gekennzeichnet, dass an dem Übergang der intrinsischen Grenzschicht zur restlichen intrinsischen Schicht die Wasserstoffkonzentration um wenigstens 30% zunimmt.

3. Dünnschichtsolarzelle nach Anspruch 1 oder 2, dadurch gekennzeichnet, dass die intrinsische Grenzschicht eine Schichtdicke von mindestens 5 nm und weniger als 50 nm aufweist.

4. Verfahren zur Herstellung einer Dünnschichtsolarzelle mit wenigstens einer p-leitenden Schicht, einer darauf abgeschiedenen intrinsischen Schicht aus amorphem Silizium und einer auf der intrinsischen Schicht abgeschiedenen n-leitenden Schicht (p-i-n-Struktur) auf einem Substrat, bei dem zur thermokatalytischen Abscheidung (Hot-Wire-Verfahren) der intrinsischen Schicht ein erhitzter Draht verwendet wird, dem ein Siliziumwasserstoffgas zugeführt wird, dadurch gekennzeichnet, dass die Temperatur des Substrates während der Abscheidung der intrinsischen Schicht auf weniger als 300°C eingestellt wird.

5. Verfahren nach Anspruch 4, dadurch gekennzeichnet, dass die Temperatur des Drahtes in der Anfangsphase der Abscheidung zur Bildung einer intrinsischen Grenzschicht weniger als 1600°C beträgt und anschließend für die Abscheidung der intrinsischen Hauptschicht erhöht wird.

6. Verfahren nach Anspruch 5, dadurch gekennzeichnet, dass die Abscheiderate in der Anfangsphase zur Bildung der intrinsischen Grenzschicht höchstens 2,5 Å/s beträgt.

7. Verfahren nach Anspruch 5, dadurch gekennzeichnet, dass die Abscheiderate nach Bildung der intrinsischen Grenzschicht mindestens um das 2-fache zur Bildung der intrinsischen Hauptschicht erhöht wird.

8. Verfahren nach Ansprüchen 4 bis 7, dadurch gekennzeichnet, dass als Siliziumwasserstoffgas Silan verwendet wird, das mit Wasserstoff verdünnt ist.

9. Verfahren nach Anspruch 8, dadurch gekennzeichnet, dass als erhitzter Draht ein Tantaldraht verwendet wird.

10. Vorrichtung zur Durchführung des Verfahrens nach einem der Ansprüche 4 bis 9, dadurch gekennzeichnet, dass sie als evakuierbare Kammer ausgebildet ist, in der ein Substrathalter und planparallel im Abstand von dem Substrathalter ein Gitter angeordnet ist, das aus einem Rahmen (1) besteht, an dem ein Tantal-Draht (4) mäanderförmig aufgespannt ist, und dass zum Spannen des Tantaldrahtes (5) wenigstens ein Gewicht (7) an dem Tantal-Draht (4) angreift.

FIG. 1

FIG. 2

FIG. 3

FIG. 4

<table>
<tr><td><strong>Europäisches Patentamt</strong></td><td><strong>EUROPÄISCHER RECHERCHENBERICHT</strong></td><td><strong>Nummer der Anmeldung</strong><br>EP 98 10 5897</td></tr>
</table>

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | BAUER S ET AL: "A-Si:H solar cells using the hot-wire technique-how to exceed efficiencies of 10%" CONFERENCE RECORD OF THE TWENTY SIXTH IEEE PHOTOVOLTAIC SPECIALISTS CONFERENCE – 1997 (CAT. NO.97CB36026), CONFERENCE RECORD OF THE TWENTY SIXTH IEEE PHOTOVOLTAIC SPECIALISTS CONFERENCE – 1997, ANAHEIM, CA, USA, 29 SEPT.-3 OCT. 1997, ISBN 0-7803-3767-0, 1997, NEW YORK, NY, USA, IEEE, USA, Seiten 719-722, XP002074369 * das ganze Dokument * | 1-10 | H01L31/075 H01L31/0376 H01L31/20 |
| X | BAUER S ET AL: "P-I INTERFACE ENGINEERING AND I-LAYER CONTROL OF HOT-WIRE A-SI:H BASED P-I-N SOLAR CELLS USING IN-SITU ELLIPSOMETRY" SOLAR ENERGY MATERIALS AND SOLAR CELLS, Bd. 43, Nr. 4, 15.Oktober 1996, Seiten 413-424, XP000628309 * das ganze Dokument * | 1-10 | |
| A | MIDDYA A R ET AL: "FAST DEPOSITION OF POLYCRYSTALLINE SILICON FILMS BY HOT-WIRE CVD" AMORPHOUS SILICON TECHNOLOGY 1995, SAN FRANCISCO, APRIL 18 – 21, 1995, Nr. VOL. 377, 18.April 1995, HACK M ET AL (ED ), Seiten 119-124, XP000656328 * Abbildung 1 * | 10 | **RECHERCHIERTE SACHGEBIETE (Int.Cl.6)**<br><br>H01L<br>C23C |

Der vorliegende Recherchenbericht wurde für alle Patentansprüche erstellt

| Recherchenort | Abschlußdatum der Recherche | Prüfer |
|---|---|---|
| MÜNCHEN | 13.August 1998 | Eliasson, G |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
 
& : Mitglied der gleichen Patentfamilie, übereinstimmendes Dokument

EPO FORM 1503 03.82 (P04C03)